# EUROPEAN PATENT APPLICATION

(11) **EP 0 697 467 A1**
(43) Date of publication of application: **21.02.1996**
(21) Application number: 95304784.2
(22) Date of filing: 10.07.1995
(51) Int. Cl.: C23C 16/44, H01J 37/32

(54) **Method and apparatus for cleaning a deposition chamber**

(30) Priority: 21.07.1994 US 278605
(71) Applicant: APPLIED MATERIALS, INC., Santa Clara California 95054-3299 (US)
(72) Inventor: Shang, Quanyuan, San Jose, California 95129 (US); Law, Kam S., Union City, California 94587 (US); Maydan, Dan, Los Altos Hills, California 94022 (US)
(74) Representative: Bayliss, Geoffrey Cyril

(57) **Abstract**

A method for cleaning a deposition chamber (10) that is used in fabricating electronic devices including the steps of delivering a precursor gas into a remote chamber (46) that is outside the deposition chamber, activating the precursor gas in the remote chamber using a microwave generator (48) to form a reactive species, flowing the reactive species from the remote chamber into the deposition chamber via conduit (57), and using the reactive species that is flowed into the deposition chamber from the remote chamber to clean the inside of the deposition chamber.

## Description

Plasma assisted chemical reactions have been widely used in the semiconductor and flat panel display industries. One example is plasma-enhanced chemical vapor deposition (PECVD), which is a process that is used in the manufacture of thin film transistors (TFT) for active-matrix liquid crystal displays (AMLCDs). In accordance with PECVD, a substrate is placed in a vacuum deposition chamber that is equipped with a pair of parallel plate electrodes. One of the electrodes, e.g. the lower electrode, generally referred to as a susceptor, holds the substrate. The other electrode, i.e., the upper electrode, functions as a gas inlet manifold or shower head. During deposition, a reactant gas flow into the chamber through the upper electrode and a radio frequency (RF) voltage is applied between the electrodes to produce a plasma within the reactant gas. The plasma causes the reactant gas to decompose and deposit a layer of material onto the surface of the substrate.

Though such systems are designed to preferentially deposit the material cnto the surface of the substrate, they also deposit some material onto other interior surfaces within the chamber. Consequently, after repeated use, these systems must be cleaned to remove the deposited layer of material that has built up in the chamber. To clean the chamber and the exposed components within the chamber, an in-situ dry cleaning process is commonly used. According to the in-situ technique, precursor gases are supplied to the chamber. Then, by locally applying a glow discharge plasma to the precursor gases within the chamber, reactive species are generated. The reactive species clean the chamber surfaces by forming volatile compounds with the process deposit on those surfaces.

This in-situ cleaning technique has several disadvantages. First, it is inefficient to use a plasma within the chamber to generate the reactive species. Thus, it is necessary to use relatively high powers to achieve an acceptable cleaning rate. The high power levels, however, tend to produce damage to the hardware inside of the chamber thereby significantly shortening its useful life. Since the replacement of the damaged hardware can be quite costly, this can significantly increase up the per substrate cost of product that is processed using the deposition system. In the current, highly competitive semiconductor fabrication industry where per substrate costs are critical to the cost conscious purchasers, the increased operating costs resulting from having to periodically replace parts that are damaged during the cleaning process is very undesirable.

Another problem with the conventional in-situ dry cleaning processes is that the high power levels that are required to achieve acceptable cleaning rates also tend to generate residues or byproducts that can damage other system components or which cannot be removed except by physically wiping off the internal surfaces of the chamber. For example, in a Si₃N₄ deposition system which uses NF₃ for cleaning, NₓH_{y}F_{z} compounds tend to be generated. These ammonium compounds deposit in the vacuum pump where they can negatively affect the reliability of the pump. As another example, in a deposition system in which the chamber or the process kit components (e.g. heater, shower head, clamping rings, etc.) are made of aluminum, an NF₃ plasma is often used to clean the interior surfaces. During the cleaning process, a certain amount of AlₓF_{y} is formed. The amount that is formed is greatly increased by the ion bombardment that results from the high plasma energy levels. Thus, a considerable amount of AlₓF_{y} can be formed in the system. Unfortunately, this material cannot be etched away by any known chemical process, so it must be removed by physically wiping the surfaces.

In accordance with the present invention, a remote excitation source is used outside of the process chamber to generate a reactive species which is then supplied to the process chamber to assist in carrying out a particular process, e.g. dry cleaning the chamber. In the case of the dry cleaning process, the remote excitation source breaks down the feed gas (e.g. a compound of chlorine or fluorine) to form a long lived halogen species. A second local excitation source may then optionally be used inside the chamber to sustain the long lived species and/or to further break down the gas to form the reactive species. Since the remote excitation source is relied upon to generate the reactive species, the local excitation source may be operated at much lower power levels than are required in a conventional systems. Thus, by moving the excitation source outside of the chamber, high plasma power levels are no longer needed inside the chamber to achieve acceptable cleaning rates. Indeed, in some cases it may not even be necessary to use any local excitation source (e.g. plasma) within the chamber.

In general, in one aspect, the invention is a method for cleaning a deposition chamber that is used in fabricating electronic devices. The method includes the following steps: delivering a precursor gas into a remote chamber that is separate from the deposition chamber; activating the precursor gas in the remote chamber to form a reactive species; flowing the reactive species from the remote chamber into the deposition chamber; and using the reactive species that is flowed into the deposition chamber from the remote chamber to clean the inside of the deposition chamber.

In general, in another aspect, the invention is a method of performing a process to fabricate electronic devices within a process chamber. The method includes the steps of: delivering a precursor gas into a remote chamber that is separate from the process chamber; activating the precursor gas in the remote chamber to form a reactive species; flowing the reactive species from the remote chamber into the process chamber; using a local activation source to further excite the reactive species that has been flowed into the process chamber from the remote chamber; and using the reactive species that has been further excited by the local activation source in performing the fabrication process in the process chamber.

In general, in yet another aspect, the invention is a deposition apparatus that can be connected to a source of precursor gas for cleaning. The apparatus includes a deposition chamber, a first activation source adapted to deliver energy into the deposition chamber, a remote chamber that is separate from the deposition chamber, a second activation source separate from the first activation source and adapted to deliver energy into the remote chamber, a first conduit for flowing a precursor gas from a remote gas supply into the remote chamber where it is activated by the second activation source to form a reactive species, and a second conduit for flowing the reactive species from the remote chamber into the deposition chamber.

Technically, the remote plasma is used to generate reactive species. To help solve the problem of quenching of the reactive species while its flowing to the chamber a mild plasma may be applied in the process chamber to assist the cleaning. The use of the combined plasma sources achieves a better cleaning rate than would be associated with using either a local or a remote plasma alone. In addition, because of the invention permits the use of a low energy plasma (or even no plasma) within the deposition chamber, much less damage is done to the internal chamber components as a result of the cleaning process and there is much less formation of particulates and undesirable byproducts, such as AlₓF_{y}, the disadvantages of which were described above. In addition, in embodiments which use both remote and local excitation sources, each source can be independently adjusted to achieve optimum results. Moreover, in the case that a local plasma is not available in the system, some other activation techniques may be applied (such as thermal excitation).

A further advantage of the invention is that unwanted byproducts that are formed when activating the reactive species can easily be filtered out before the reactive species enters the deposition chamber. In addition, use of the local source to sustain the activated species lessens the restrictions that might exist on the placement of the remote activation chamber. That is, the remote activation chamber can be placed conveniently, even at further distances from the deposition chamber, with less concern about quenching of the activated species as it is being transferred from the remote chamber to the deposition chamber. This means that it will be relatively easy to retrofit existing systems with this capability.

Using the combination of remote and local excitation sources has the further advantage that it can be applied to a wide variety of applications and systems with similar benefits. For example, it can also be used in PVD and CVD systems, plasma etching systems, and systems for cleaning substrates, ion doping, and stripping of photoresist.

Other advantages and features will become apparent from the following description of the preferred embodiment and from the claims.

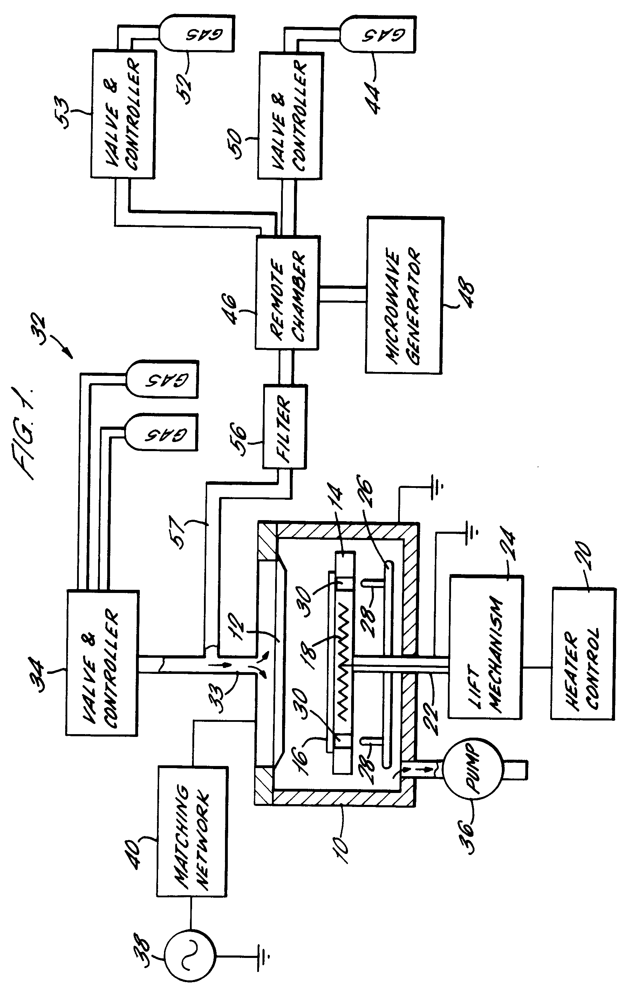

Fig. 1 shows a block diagram of a PECVD system which embodies the invention.

In the described embodiment, we used a model AKT-1600 PECVD System manufactured by Applied Komatsu Technology, modified as described herein. The AKT-1600 PECVD is designed for use in the production of active-matrix liquid crystal displays (AMLCDs). It is a modular system with multiple process chambers which can be used for depositing amorphous silicon, silicon nitride, silicon oxide and oxynitride films. The invention, however, may be used with any commercially available deposition system.

Referring to Fig. 1, the PECVD system modified in accordance with invention includes a deposition chamber 10 inside of which is a gas inlet manifold (or shower head) 12 for introducing deposition gases and a susceptor 14 for holding a substrate 16 onto which material is to be deposited. The inlet manifold 12 and the susceptor 14, which are both in the form of parallel plates, also function as upper and lower electrodes, respectively. The lower electrode and the chamber body are connected to ground. An RF generator 38 supplies RF power to the upper electrode through a matching network 40. The RF generator 38 is used to generate a plasma between the upper and lower electrodes.

The susceptor 14 includes a resistive heater 18 for heating the substrate during deposition. An external heater control module 20 powers the heaters to achieve and maintain the susceptor at an appropriate temperature level as dictated by the process being run in the system.

The susceptor is attached to the top of a movable shaft 22 that extends vertically through the bottom of the chamber. A motorized lift mechanism 24 moves the shaft in a vertical direction so as to raise the susceptor into position near the inlet manifold for a deposition run and to lower the susceptor after completing the deposition run. The separation between the upper and lower electrodes is adjustable to maximize reaction kinetics and film characteristics for the particular deposition process that is being performed. Below the susceptor there is a lift-off plate 26 with a set of vertical pins 28. The pins 28 are aligned with corresponding holes 30 in the susceptor 14. When the susceptor is lowered after a processing run, the pins pass through the holes, contact the back side of the substrate, and lift the substrate off of the susceptor so that it can be more easily removed from the chamber by a mechanical transfer mechanism (not shown).

Outside of chamber 10, there is a gas supply 32 containing the gases that are used during deposition. The particular gases that are used depend upon the materials are to be deposited onto the substrate. The process gases flow through an inlet port into the gas manifold and then into the chamber through the shower head. An electronically operated valve and flow control mechanism 34 controls the flow of gases from the gas supply into the chamber. Also connected to the chamber through an outlet port is a vacuum pump 36, which is used to evacuate the chamber.

In accordance with the invention, a second gas supply system is also connected to the chamber through inlet port 33. The second gas supply system supplies gas that is used to clean the inside of the chamber after a sequence of deposition runs. By cleaning, we mean removing deposited material from the interior surfaces of the chamber.

The second gas supply system includes a source of a precursor gas 44, a remote activation chamber 46 which is located outside and at a distance from the deposition chamber, a power source 48 for activating the precursor gas within the remote activation chamber, an electronically operated valve and flow control mechanism 50, and a statinless steel conduit or pipe 57 connecting the remote chamber to the deposition chamber. The valve and flow control mechanism 50 delivers gas from the source of precursor gas 44 into the remote activation chamber 46 at a user-selected flow rate. The power source 48 activates the precursor gas to form a reactive species which is then flowed through the conduit 57 into the deposition chamber via inlet port 33. In other words, the upper electrode or shower head 12 is used to deliver the reactive gas into the deposition chamber. In the described embodiment, the remote chamber is a quartz tube and the power source is a 2.54 GHz microwave generator with its output aimed at the quartz tube.

Optionally, there may also be a source of a minor carrier gas 52 that is connected to the remote activation chamber through another valve and flow control mechanism 53. The minor carrier gas aids in the transport of the activated species to the deposition chamber. It can be any appropriate nonreactive gas that is compatible with the particular cleaning process with which it is being used. For example, the minor carrier gas may be argon, nitrogen, helium, hydrogen, or oxygen, etc. In addition to aiding in the transport of activated species to the deposition chamber, the carrier gas may also assist in the cleaning process or help initiate and/or stabilize the plasma in the deposition chamber.

In the described embodiment, there is a filter 56 in the conduit or pipe through which the activated species passes before entering the deposition chamber. The filter removes particulate matter that might have been formed during the activation of the reactive species. In the described embodiment, the filter is a made of ceramic material having a pore size of about 0.01 to 0.03 microns. Of course, other materials can also be used, for example, teflon.

It should be noted that the filter can also be used to remove unwanted materials that might have been produced as byproducts of the reaction within the remote chamber. For example, if the reactive gas is CF₄ or SF₆ or some other halogen compound containing either carbon or sulfur, an activated carbon or sulfur species will be present as a byproduct of the activation process. It is generally desired, however, that carbon and sulfur not be present in the deposition chamber. This is why these compounds are generally not used in conventional dry cleaning process where the activation occurs entirely within the deposition chamber. However, when the activation is performed remotely, as described herein, these materials can be easily removed by using an appropriate filter material. Such filter materials are readily available in the commercial market and are well know to persons of ordinary skill in the art.

In the described embodiment, the precursor is NF₃. The flow rate of activated species is about 2 liters per minute and the chamber pressure is about 0.5 Torr. To activate the precursor gas, the microwave source delivers about 500-1500 Watts to the activation chamber. Within the deposition chamber, the RF sources supplies about 100-200 Watts to the plasma. For the AKT-1600 PECVD system this implies a voltage between the upper and lower electrodes of about 15-20 volts. Of course, the precise voltage and current are pressure dependent, i.e., the current is proportional to the pressure given a fixed voltage. In any event, it is only necessary to induce a gentle plasma within the chamber, which only need be strong enough to sustain the activated species that has been flowed into the chamber from the remote source.

By using NF₃ as the feed gas, we have been able to clean chambers that have been deposited with silicon (Si), doped silicon, silicon nitride (Si₃N₄) and silicon oxide (SiO₂). The cleaning rate for as-deposited film has reached 2 micron/minute for silicon nitride and 1 micron/minute for silicon, doped silicon, and silicon oxide. These cleaning rates are two to four time faster than the conventional cleaning process which employs only a local plasma with a power level of about 2 kilowatts at 13.56 MHz RF.

Though a microwave generator was used in the described embodiment to activate the precursor gas, any power source that is capable of activating the precursor gas can be used. For example, both the remote and local plasmas can employ DC, radio frequency (RF), and microwave (MW) based discharge techniques. In addition, if an RF power source is used, it can be either capacitively or inductively coupled to the inside of the chamber. The activation can also be performed by a thermally based, gas break-down technique; a high intensity light source; or an X-ray source, to name just a few.

In general, the reactive gases may be selected from a wide range of options, including the commonly used halogens and halogen compounds. For example, the reactive gas may be chlorine, fluorine or compounds thereof, e.g. NF₃, CF₄, SF₆, C₂F₆, CCl₄, C₂Cl₆. Of course, the particular gas that is used depends on the deposited material which is being removed. For example, in a tungsten deposition system a fluorine compound gas is typically used to etch and/or remove clean the deposited tungsten.

Because of the use of a local plasma in conjunction with the remote plasma, the remote activation chamber can be placed farther away from the chamber. Thus, only tubing is needed to connect the two remote source to the local source. Some quenching of the activated species (i.e., deactivation of the activated species) may occur during the transfer. However, the local source compensates for any such quenching that may occur. In fact, some long lived activated species (e.g. F*) typically do not return to the ground state when quenched but rather they transition to an intermediate state. Thus, the amount of energy that is required to reactivate the quenched species is much less than is required to activate the gas in the remote activation chamber. Consequently, the local activation source (e.g. plasma) need not be a high energy source.

It should also be noted that by placing the remote source at a distance from the deposition chamber, the short lived radicals that are produced during the activation process will be quenched more completely than the long lived radicals as both are transferred to the deposition chamber. Thus, the reactive gas that flows into the deposition chamber will contain primarily the long lived radicals that have survived the transfer. For example, if NF₃ is the reactive gas, two radicals are produced in the remote activation chamber, namely, N* and F*. The nitrogen radical is short lived and the fluorine radical is long lived. The nitrogen radical will typically not survive a long transfer from the remote chamber to the deposition chamber; whereas, a large percentage of the fluorine radicals will survive. This is a form of natural filtering that occurs in the system that may be very desirable. In the case of nitrogen radicals, for example, it is sometimes preferable that they not be present in the deposition chamber because their presence may result in the formation of NₓH_{y}F_{z} compounds, which, as previously described, can harm the pump. When the activation is performed in the deposition chamber, however, as in the case of conventional cleaning techniques, there is no easy way to eliminate the nitrogen radicals that are produced.

In the dry cleaning process, chamber pressure can be selected to lie anywhere within a fairly broad range of values without significantly affecting performance. The preferred pressure range is from about 0.1 to about 2 Torr, although pressures outside of that range can also be used. In addition, the frequencies that were chosen for the described embodiment were merely illustrative and the frequencies that may be used in the invention are not restricted to those used in the described embodiment. For example, with regard to the RF power source, any of a wide range of frequencies (e.g. 400 kHz to 13.56 MHz) are typically used to generate plasmas and those frequencies may also be used in the invention. In general, however, it should be understood that the power levels, flow rates, and pressures that are chosen are system specific and thus they will need to be optimized for the particular system in which the process is being run. Making the appropriate adjustments in process conditions to achieve optimum of performance for a particular system is well within the capabilities of a person of ordinary skill in the art.

Although the described embodiment involved a PECVD system, the invention has far wider applicability. For example, the concept of a remote activation source (i.e., outside the main vacuum chamber), possibly used in conjunction with a local activation source (i.e., inside the main vacuum chamber) can be used in systems designed for any of the following purposes: PVD, CVD, ion doping, photoresist stripping, substrate cleaning, plasma etching.

Other embodiments are within the following claims.

## Claims

1. A method for cleaning a deposition chamber that is used in fabricating electronic devices, said method comprising:
delivering a precursor gas into a remote chamber that is outside of the deposition chamber;
activating the precursor gas in the remote chamber to form a reactive species;
flowing the reactive species from the remote chamber into the deposition chamber; and
using the reactive species that is flowed into the deposition chamber from the remote chamber to clean the inside of the deposition chamber.

2. The method of claim 1 wherein the step of activating the precursor gas is performed by using a remote energy source.

3. The method of claim 1 further comprising using a local energy source to further excite the reactive species that has been flowed into the deposition chamber from the remote chamber.

4. The method of claim 3 wherein the precursor gas is selected from the group of gases consisting of all halogens and gaseous compounds thereof.

5. The method of claim 4 wherein the precursor gas is selected from the group of gases consisting of chlorine, fluorine, and gaseous compounds thereof.

6. The method of claim 2 wherein the remote energy source is a microwave energy source.

7. The method of claim 6 wherein the precursor gas is selected from the group of gases consisting of all halogens and gaseous compounds thereof.

8. The method of claim 7 wherein the precursor gas is selected from the group of gases consisting of chlorine, fluorine, and compounds thereof.

9. The method of claim 2 wherein the local energy source is an RF energy source for generating a plasma within the deposition chamber.

10. The method of claim 2 further comprising filtering the reactive species before it enters the deposition chamber to remove unwanted materials.

11. The method of claim 2 further comprising flowing a carrier gas into the remote activation chamber.

12. The method of claim 11 wherein the carrier gas is selected from the group of gases consisting of nitrogen, argon, helium, hydrogen, and oxygen.

13. A method of performing a process to fabricate electronic devices within a process chamber, said method comprising:
delivering a precursor gas into a remote chamber that is outside of the process chamber;
activating the precursor gas in the remote chamber and to thereby form a reactive species;
flowing the reactive species from the remote chamber into the process chamber;
using a local activation source to further excite the reactive species that has been flowed into the process chamber from the remote chamber; and
using the reactive species that has been further excited by the local activation source in performing the fabrication process in the process chamber.

14. The method of claim 13 wherein the step of activating the precursor gas is performed by using a remote energy source.

15. The method of claim 13 wherein the precursor gas is selected from a group of gases consisting of halogen gases and compounds thereof.

16. The method of claim 15 wherein the precursor gas is selected from a group of gases consisting of chlorine, fluorine, and compounds thereof.

17. The method of claim 14 wherein the remote energy source is a microwave energy source.

18. The method of claim 17 wherein the precursor gas is selected from a group of gases consisting of halogen gases and compounds thereof.

19. The method of claim 18 wherein the precursor gas is selected from a group of gases consisting of chlorine, fluorine, and compounds thereof.

20. The method of claim 13 wherein the local energy source is an RF energy source for generating a plasma within the process chamber.

21. The method of claim 13 further comprising filtering the reactive species before it enters the deposition chamber to remove unwanted materials.

22. The method of claim 13 further comprising flowing a carrier gas into the remote activation chamber.

23. The method of claim 22 wherein the carrier gas is selected from a group of gases consisting of nitrogen, argon, helium, hydrogen, and oxygen.

24. A deposition apparatus that can be connected to a source of precursor gas for cleaning, said apparatus comprising:
a deposition chamber;
a first activation source adapted to deliver energy into said deposition chamber;
a remote chamber that is outside of said deposition chamber;
a second activation source separate from said first activation source and adapted to deliver energy into said remote chamber;
a first conduit for flowing a precursor gas from a remote gas supply into the remote chamber where it is activated by said second activation source to form a reactive species; and
a second conduit for flowing the reactive species from the remote chamber into the deposition chamber.

25. The apparatus of claim 24 further comprising a valve and flow control mechanism which controls the flow of precursor gas into the remote chamber.

26. The apparatus of claim 25 further comprising a valve and flow control mechanism which controls the flow of a carrier gas that is different from the precursor gas into the remote chamber.

27. The deposition apparatus of claim 25 further comprising a filter in the second conduit to remove unwanted materials out of the flow of reactive species from the remote chamber.
